# EUROPÄISCHE PATENTANMELDUNG

(11) **EP 0 633 718 A1**
(43) Veröffentlichungstag der Anmeldung: **11.01.1995**
(21) Anmeldenummer: 94109272.8
(22) Anmeldetag: 16.06.1994
(51) Int. Cl.: H05K 9/00

(54) **Verfahren zum Herstellen von Abschirmungen für elektrische und/oder elektronische Bauteile, Geräte oder Anlagen sowie nach diesem Verfahren hergestellte Abschirmvorrichtung**

(30) Priorität: 07.07.1993 DE 4322551
(71) Anmelder: DURMONT TEPPICHBODENFABRIK AG, A-2435 Ebergassing (AT)
(72) Erfinder: Huber, Anton, Dipl.-Ing., A-2560 Berndorf (AT)
(74) Vertreter: Müller, Gerd, Dipl.-Ing.

(57) **Zusammenfassung**

Es wird ein Verfahren zum Herstellen von Abschirmungen für den Schutz elektrischer und/oder elektronischer Bauteile, Geräte oder Anlagen gegenüber elektrischen oder magnetischen Störfeldern beschrieben, welches dadurch gekennzeichnet ist, daß in einen begrenzten Formhohlraum 4 eines Spritzgießwerkzeuges 1 ein Vlies, ein Sieb, ein Gewirke oder ein Gewebe 7 aus einem metallischen, zumindest aber elektrisch leitfähigen Werkstoff flächendeckend eingebracht und dann durch wenigstens einseitiges An- oder Aufspritzen einer Kunststoffmaterial-Schicht 8 zu einem Verbund-Baukörper 6 stabilisiert wird.

## Beschreibung

Für den Schutz elektrischer und/oder elektronischer Bauteile, Geräte oder Anlagen gegenüber elektrischen oder magnetischen Störfeldern werden in der Elektrotechnik Abschirmvorrichtungen benötigt, mit denen man entweder die Quelle des Feldes oder aber die abzuschirmenden Teile umgibt. Bei der elektrostatischen Abschirmung wird dabei durch Becher, Folien, Platten oder Geflechte aus elektrisch gut leitenden Materialien ein Aus- oder Eintreten von Feldlinien - nach Art des Faraday-Käfigs - verhindert. Dabei werden die Abschirmvorrichtungen mit einem bestimmten Potentialpunkt, meist mit der "Masse" (Erde) verbunden.

Eine magnetische Abschirmung läßt sich bei statischen oder niederfrequenten Magnetfeldern durch Umhüllungen aus ferromagnetischen Materialien hoher Permeabilität erreichen, während bei hochfrequenten elektromagnetischen Feldern unmagnetische, aber elektrisch gut leitende Stoffe verwendet werden. Die in den Abschirmvorrichtungen induzierten Wirbelströme entziehen dabei dem einwirkenden Feld Energie (vgl. Meiers Lexikon der Technik und exakten Naturwissenschaften, 1. Band, 1969, Seite 46).

Bei Gehäusen für elektrische und elektronische Bauteile, Geräte oder Anlagen hat es sich bis heute als relativ problematisch erwiesen, diese auf möglichst einfache Art und Weise sowie zugleich auch kostengünstig so weit abzuschirmen, daß störende Einflüsse von außen nach innen oder aber von innen nach außen ausreichend wirksam ausgeschaltet werden können. Die übliche Anordnung von Maschengittern, deren Maschenweite klein gegenüber der Wellenlänge des einwirkenden Wechselfeldes ist, auf der Innenseite oder der Außenseite der Gehäuse genügt in den meisten Fällen den gestellten Anforderungen nicht, weil diese in sich instabil sind und dadurch wegen ihrer exponierten Einbaulage leicht beschädigt bzw. zerstört werden können.

Die Erfindung betrifft ein Verfahren zum Herstellen von Abschirmungen für den Schutz elektrischer und/oder elektronischer Bauteile, Geräte oder Anlagen gegenüber elektrischen oder magnetischen Störfeldern, welches darauf abzielt, die den bekannten Abschirmungen eigentümlichen Unzulänglichkeiten auszuräumen und die Schaffung von Abschirmvorrichtungen zu ermöglichen, denen eine für den jeweiligen Einsatz zweckoptimale Formstabilität bei möglichst geringem Materialaufwand eigentümlich ist.

Die erfindungsgemäße Verfahrensart ist dabei in erster Linie dadurch gekennzeichnet, daß in einen begrenzten (Form-)Hohlraum ein Vlies, ein Sieb, ein Gewirke oder Gewebe aus einem metallischen, zumindest aber elektrisch leitfähigen Werkstoff flächendeckend eingebracht und dann durch wenigstens einseitiges An- oder Aufspritzen bzw. - prägen einer Kunststoffmaterial-Schicht zu einem Baukörper stabilisiert wird.

Bei einer nach diesem Herstellungsverfahren gefertigten Abschirmvorrichtung bildet die Kunststoffmaterial-Schicht die eigentliche tragende Wand eines (Gehäuse-)Baukörpers, welche sich in ihren Abmessungen und hinsichtlich ihrer Struktur sowie Werkstoffauswahl auf die unterschiedlichsten Bedürfnisse abstimmen läßt und dabei als Integrand die unter Aufwendung des unbedingt notwendigen Materialanteil erstellte Abschirmung trägt bzw. stützt.

Bewährt hat es sich nach der Erfindung besonders, wenn das metallische und/oder elektrisch leitfähige Vlies, Sieb, Gewirke oder Gewebe durch das Einspritzen bzw. Spritzprägen des schmelzflüssigen Kunststoffmaterials in den (Form-)Hohlraum von der jeweiligen Einspritzseite weg gegen die Hohlraumwandung hin verdrängt bzw. an diese angelegt und/oder gepreßt sowie dabei entsprechend dem Verlauf dieser Hohlraumwandung konturiert wird.

Die erfindungsgemäße Verfahrensart macht sich eine bei der textilen Hinterspritztechnik angewandte Fertigungstechnologie zunutze. Diese besteht darin, daß ein textiler Dekorträger in den Formhohlraum bzw. die Kavität eines Spritzgießwerkzeuges eingebracht und dann dem Spritzdruck eines gegen seine Rückseite gerichteten schmelzflüssigen Kunststoffmaterial unterworfen wird. Der einströmende Kunststoff verbindet sich hierbei mit dem Dekorträger zu einem stabilen und optisch perfekt dekorierten Verbundwerkstoff-Formteil, das ohne eine zusätzliche Klebstoffverbindung auskommt und sich daher sowohl von der Dekorseite als auch von der Kunststoffseite her recyclinggerecht auslegen läßt.

Die entsprechenden Vorteile sind damit erfindungsgemäß auch für die Schaffung von Abschirmungen für den Schutz elektrischer und/oder elektronischer Bauteile, Geräte und Anlagen erreicht.

Die erfindungsgemäße Verfahrensart läßt sich in vorteilhafter Weise auch so nutzen, daß das aus einem metallischen, zumindest aber elektrisch leitfähigen Werkstoff bestehende Vlies, Sieb, Gewirke oder Gewebe durch das Einbringen in den (Form-)Hohlraum des Spritzgießwerkzeuges vorkonturiert und durch das daran anschließende Einspritzen des schmelzflüssigen Kunststoffmaterials von der Einspritzseite weg gegen die Hohlraumwandung angelegt und/oder gepreßt wird.

Eine nach dem vorstehend erläuterten Verfahren hergestellte Abschirmvorrichtung für den Schutz elektrischer und/oder elektronischer Bauteile, Geräte oder Anlagen gegenüber elektrischen oder magnetischen Störfeldern ist im wesentlichen dadurch gekennzeichnet, daß ein Vlies, ein Sieb, ein Gewirke oder Gewebe aus einem metallischen, zumindest aber elektrisch leitfähigen Werkstoff flächendekkend mit einer wenigstens einseitig an- und/oder aufgespritzten bzw. -geprägten Kunststoffmaterial-Schicht ein in sich formstabiles Verbund-Bauelement bildet.

Der Abschirmteil kann dabei zum Zwecke der Ausübung seiner Schutzwirkung mit einem bestimmten Potentialpunkt, bspw. mit der Masse oder Erde verbunden werden.

Wird eine Abschirmvorrichtung mit der vorstehend angegebenen Merkmalsausstattung insbesondere zum Um- oder Einschließen der Quelle eines Störfeldes eingesetzt, dann ist es zu empfehlen, daß der Abschirmteil an der Rück- oder Innenseite des Verbund-Bauelementes liegt.

Geht es hingegen darum, die Abschirmvorrichtung insbesondere zum Um- oder Einschließen abzuschirmender Teile in Gebrauch zu nehmen, dann ist zu empfehlen, daß der Abschirmteil an der Vorder- oder Außenseite des Verbund-Bauelementes vorgesehen ist.

Anhand der Zeichnung wird die Erfindung nachfolgend an Ausführungsbeispielen näher erläutert. Hierbei zeigen
- Figur 1: in schematisch vereinfachter Schnittdarstellung die Herstellung eines mit einer Abschirmvorrichtung für den Schutz elektrischer und/oder elektronischer Bauteile, Geräte oder Anlagen gegenüber elektrischen oder magnetischen Störfeldern ausgestatteten Verbund-Bauelementes in einer ersten möglichen Bauform, und
- Figur 2: in einer entsprechend schematischen Schnittdarstellung die Herstellung einer anderen Bauform des mit einer solchen Abschirmung ausgestatteten VerbundBauelementes.

In beiden Zeichnungsfiguren ist jeweils ein Spritzgießwerkzeug 1 zu sehen, das von einer festen Werkzeughälfte 2 und einer beweglichen Werkzeughälfte 3 gebildet wird und zwischen diesen einen Formhohlraum bzw. eine Kavität 4 von bestimmter Form und Größe einschließen kann, wenn das Spritzgießwerkzeug 1 geschlossen ist.

Mit dem Formhohlraum bzw. der Kavität 4 steht ein durch die feste Werkzeughälfte 2 führender Angußkanal 5 in Verbindung, der von einer Plastifiziereinheit bzw. einem Extruder mit Kunststoffschmelze beaufschlagt werden kann.

Mit Hilfe des Spritzgießwerkzeuges 1, nämlich in dessen Formhohlraum bzw. Kavität 4 lassen sich Verbund-Baukörper 6 herstellen, die einerseits ein Vlies, ein Sieb, ein Gewirke oder ein Gewebe 7 aus einem metallischen, zumindest aber elektrisch leitfähigen Werkstoff umfassen und andererseits eine durch An- oder Aufspritzen gebildete Kunststoffmaterial-Schicht 8 aufweisen.

Für die Herstellung des Verbund-Baukörpers 6 wird zunächst das Vlies, das Sieb, das Gewirke oder Gewebe aus metallischem, zumindest aber elektrisch leitfähigem Werkstoff flächendeckend in den zwischen der festen Werkzeughälfte und der bewegbaren Werkzeughälfte 3 begrenzten Formhohlraum bzw. in die Kavität 4 eingebracht. Sodann wird über den Angußkanal 5 durch wenigstens einseitiges An- oder Aufspritzen von schmelzflüssigem Kunststoffmaterial die Kunststoffmaterial-Schicht 8 erzeugt und mit deren Hilfe das Vlies, Sieb, Gewirke oder Gewebe 7 von der Einspritzseite weg gegen die von der beweglichen Werkzeughälfte 3 gebildete Wandung des Formhohlraums 4 angelegt und/oder -gepreßt. Dabei wird das Vlies, Sieb, Gewirke oder Gewebe 7 entsprechend dem Verlauf dieser Wandung des Formhohlraums bzw. der Kavität 4 konturiert und zugleich eine unmittelbare und innige Verbindung desselben mit der Kunststoffmaterial-Schicht 8 herbeigeführt.

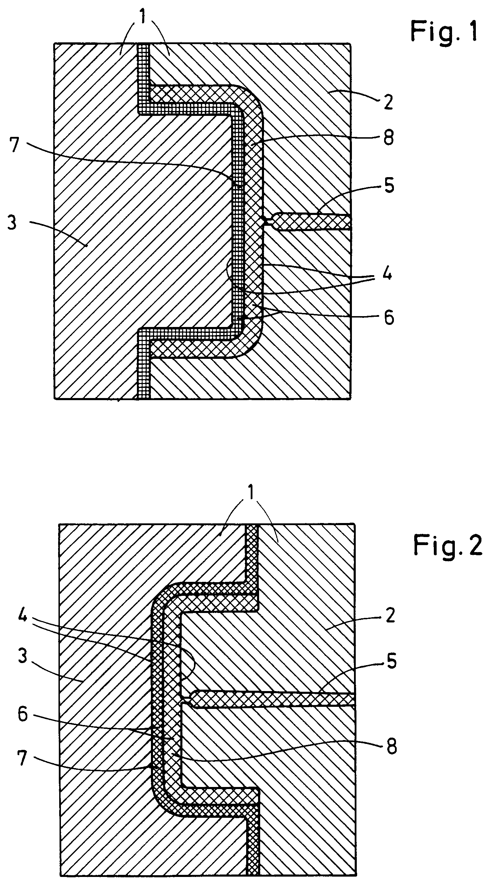

Aus den Fig. 1 und 2 der Zeichnung geht hervor, daß die feste Werkzeughälfte 2 und die bewegliche Werkzeughälfte 3 des Spritzgießwerkzeugs 1 so gestaltet werden können, daß das vor dem Schließvorgang zwischen diese eingebracht Vlies, Sieb, Gewirke oder Gewebe 7 mit dem Schließen des Formhohlraums bzw. der Kavität 4 einer Vorkonturierung unterworfen wird, deren Ausmaß von der Formgebung beider Werkzeughälften 2 und 3 abhängig ist. Bei Schließlage des Spritzgießwerkzeuges 1 werden die Randzonen des Vlieses, Siebes, Gewirkes oder Gewebes 7 in der Trennfuge zwischen den beiden Werkzeughälften 2 und 3 des Spritzgießwerkzeuges 1 festgelegt bzw. eingespannt, wie das deutlich den Fig. 1 und 2 der Zeichnung entnommen werden kann.

Nach dem Aushärten der in den Formhohlraum bzw. die Kavität 4 eingespritzten Kunststoffmaterial-Schicht 8 bildet diese mit dem Vlies, Sieb, Gewirke oder Gewebe 7 den in sich formstabilen Verbund-Baukörper, der sich bspw. zum Bau von Gehäusen nutzen läßt, die zur Aufnahme elektrischer und/oder elektronischer Bauteile, Geräte oder Anlagen dienen und dabei als Abschirmungen für den Schutz dieser Elemente gegenüber elektrischen oder magnetischen Störfeldern als Integrand das Vlies, das Sieb, das Gewirke oder das Gewebe 7 aus dem metallischen, zumindest aber elektrisch leitfähigen Werkstoff flächendeckend halten.

Je nach Einsatzzweck der Verbund-Baukörper 6 kann das deren Integrand bildende und als Abschirmung wirksame Vlies, Sieb, Gewirke oder Gewebe 7 eine unterschiedliche Anordnung erhalten. In Fig. 1 der Zeichnung ist bspw. ein Verbund-Baukörper 6 zu sehen, welcher insbesondere zum Bau von Gehäusen geeignet ist, mit denen die Quelle eines Störfeldes umschlossen oder eingeschlossen werden soll. Hier befindet sich der vom Vlies, Sieb, Gewirke oder Gewebe 7 gebildete Abschirmteil an der Rück- oder Innenseite des Verbund-Baukörpers 6.

Hingegen ist in Fig. 2 der Zeichnung ein Verbund-Baukörper 6 zu sehen, der sich insbesondere dann zum Bau von Gehäusen oder dergleichen in Benutzung nehmen läßt, die zum Um- oder Einschließen abzuschirmender Teile, Geräte oder Anlagen dienen sollen. In diesem Falle ist der von dem Vlies, Sieb, Gewirke oder Gewebe 7 gebildete Abschirmteil an der Vorder- oder Außenseite des Verbund-Baukörpers 6 vorgesehen.

Beim Spritzprägen läßt man Masse in das unter geringem Schließdruck "aufatmende" Werkzeug strömen und prägt die endgültige Form durch hohen Schließdruck. Dafür sind mindestens zwei getrennt regelbare Schließkraftstufen erforderlich.

### Liste der Bezugszeichen

- 1: Spritzgießwerkzeug
- 2: feste Werkzeughälfte
- 3: bewegliche Werkzeughälfte
- 4: Formhohlraum/Kavität
- 5: Angußkanal
- 6: Verbund-Baukörper
- 7: Vlies, Sieb, Gewirke, Gewebe
- 8: Kunststoffmaterial-Schicht

## Patentansprüche

1. Verfahren zum Herstellen von Abschirmungen für den Schutz elektrischer und/oder elektronischer Bauteile, Geräte oder Anlagen gegenüber elektrischen oder magnetischen Störfeldern,
**dadurch gekennzeichnet,**
daß in einen begrenzten Formhohlraum (4) ein Vlies, ein Sieb, ein Gewirke oder Gewebe (7) aus einem metallischen, zumindest aber elektrisch leitfähigen Werkstoff flächendeckend eingebracht und dann durch wenigstens einseitiges An- oder Auf-Spritzen bzw. -prägen einer Kunststoffmaterial-Schicht (8) zu einem Verbund-Baukörper (6) stabilisiert wird.

2. Verfahren nach Anspruch 1,
**dadurch gekennzeichnet,**
daß das metallische und/oder elektrisch leitfähige Vlies, Sieb, Gewirke oder Gewebe (7) durch das Einspritzen (5) bzw. Spritzprägen des schmelzflüssigen Kunststoffmaterials in den Formhohlraum (4) von der Einspritzseite (Angußkanal 5) weg gegen die Hohlraumwandung angelegt und/oder -gepreßt sowie dabei entsprechend dem Verlauf dieser Hohlraumwandung konturiert wird.

3. Verfahren nach einem der Ansprüche 1 und 2,
**dadurch gekennzeichnet,**
daß das Vlies, Sieb, Gewirke oder Gewebe (7) durch das Einbringen in den Formhohlraum (4) vorkonturiert wird.

4. Abschirmvorrichtung für den Schutz elektrischer und/oder elektronischer Bauteile, Geräte oder Anlagen gegenüber elektrischen oder magnetischen Störfeldern,
**dadurch gekennzeichnet,**
daß ein Vlies, Sieb, Gewirke oder Gewebe (7) mit einer wenigstens einseitig an- und/oder aufgespritzten bzw. -geprägtem Kunststoffmaterial-Schicht (8) einen in sich formstabilen Verbund-Baukörper (6) bildet, und daß dessen Abschirmteil (7) mit einem bestimmten Potentialpunkt (Masse oder Erde) verbindbar ist.

5. Abschirmvorrichtung nach Anspruch 4,
insbesondere zum Um- oder Einschließen der Quelle eines Störfeldes,
**dadurch gekennzeichnet,**
daß der Abschirmteil (7) an der Rück- oder Innenseite des Verbund-Baukörpers (6) liegt (Fig. 1).

6. Abschirmvorrichtung nach Anspruch 4,
insbesondere zum Um- oder Einschließen abzuschirmender Teile, Geräte oder Anlagen,
**dadurch gekennzeichnet,**
daß der Abschirmteil (7) an der Vorder- oder Außenseite des Verbund-Baukörpers (6) vorgesehen ist (Fig. 2).
